# EUROPEAN PATENT SPECIFICATION

(11) **EP 0 317 132 B1**
(45) Date of publication and mention of the grant of the patent: **16.03.1994**
(21) Application number: 88310363.2
(22) Date of filing: 03.11.1988
(51) Int. Cl.: H01L 29/08, H01L 21/60

(54) **A manufacturing method of a semiconductor device**
Verfahren zum Herstellen einer Halbleitervorrichtung
Procédé de fabrication d'un dispositif semi-conducteur

(30) Priority: 13.11.1987 JP 287901/87
(43) Date of publication of application: 24.05.1989
(73) Proprietor: Matsushita Electronics Corporation, Kadoma-shi, Osaka 571 (JP)
(72) Inventor: Furuta, Takashi, Takatsuki-shi Osaka (JP); Nishida, Shuichi, Nionohama Otsu-shi Shiga (JP)
(74) Representative: Crawford, Andrew Birkby

(56) References cited:
- GB-A- 2 075 255
- JAPANESE JOURNAL OF APPLIED PHYSICS, vol. 20, suppl. 20-1, 1981, pages 155-159; T. SAKAI et al.: "High speed bipolar ICs using super self-aligned process technology"

## Description

This invention relates to a manufacturing method of a semiconductor device, the device being capable of connecting an impurity diffusion region formed in a semiconductor substrate and a wiring formed on the surface of an insulation film on the semiconductor substrate stably by way of a contact hole formed in the insulation film.

In a semiconductor device, generally, an oxide film for separation of element is selectively formed on the surface of a semiconductor substrate, and an impurity diffusion region is formed in the semiconductor substrate between such oxide films. An insulation film is formed on the semiconductor substrate, and a wiring is formed on this insulation film. The impurity diffusion region and wiring are connected together by way of a contact hole formed in the insulation film.

At this time, when the area of the contact hole is wider than the area of the impurity diffusion region, part of the contact hole reaches up to the oxide film for separation of element which is adjacent to the impurity diffusion region. As a result, the wiring material formed in the contact hole directly contacts with the semiconductor substrate, which causes a so-called current leak. To avoid this problem, the area of the contact hole is usually set smaller than the area of the impurity diffusion region. Besides, the forming position of the contact hole is set at a position remote from the oxide films for separation of element in all directions adjacent to the impurity diffusion region.

Meanwhile, as the semiconductor integrated circuit is much more advanced in integration and the semiconductor element becomes finer, the area among oxide films for separation of element becomes smaller, and the area of the impurity diffusion region formed in the area tends to be smaller, too. As a result, the area of the contact hole is becoming smaller.

When the area of the contact hole becomes smaller, the contact resistance between the impurity diffusion region and wiring becomes large. Besides, the smaller the area of the impurity diffusion region, the shorter becomes the distance between the periphery of the contact hole and the edge of the oxide film for separation of element. In consequence, the patterning allowance between the impurity diffusion region and contact hole decreases, and positioning of the two becomes extremely difficult.

GB-A-2075255 discloses a method for overcoming problems caused by mis-alignment of the various masks used in the fabrication of a semiconductor device. If such mis-alignment occurs it is possible that a contact hole, which is intended to be wholly within an impurity diffusion region, will in fact overlap the edge of that region. To avoid problems caused by this a further diffusion region, which overlaps the first, is formed after the formation of the contact hole.

The present invention provides a method of manufacturing a semiconductor device comprising the steps of:
forming an oxide film defining a separation region surrounding an active region of a semiconductor device on a surface of a semiconductor substrate of a first conductive type,
forming a first impurity diffusion region of a second conductive type in said active region, wherein at least a section of the periphery of said first impurity diffusion region is adjacent to at least a section of the periphery of said separation region;
forming an insulation film over the surface of said semiconductor substrate and oxide film;
forming a contact hole in said insulation film by etching said insulation film and oxide film, the contact hole opening generally over said first impurity diffusion region, wherein a first section of the periphery of said contact hole is disposed not over said first impurity diffusion region but over said oxide film defining the separation region; and a second section of the periphery of said contact hole is disposed over said first impurity diffusion region;
forming a conductive film in electrical contact with the semiconductor substrate and said first impurity diffusion region exposed within said contact hole;
forming a second impurity diffusion region of the second conductive type in said semiconductor substrate within said contact hole through said conductive film, said second impurity diffusion region being partly overlapped with said first impurity diffusion region together forming a single impurity diffusion region having an area larger than that of said first impurity diffusion region; and
forming an electrode electrically connected to said conductive film within said contact hole, and thereby to said first and second impurity diffusion regions across substantially the whole area of said first and second impurity diffusion regions.

It is hence a principal advantage of the method of this invention that it provides a device in which the contact area between the wiring and impurity diffusion region is increased and the contact resistance is decreased, even if the area between the oxide films for separation of element is small and therefore the area of the impurity diffusion region formed in such area is small.

It is another advantage of this invention that the manufacturing method thereof is capable of positioning the impurity diffusion region and contact hole very easily by increasing the patterning allowance between them.

It is a further advantage of this invention that the manufacturing method thereof is capable of patterning the contact hole itself quite easily, so that the reliability of connection between the impurity diffusion region and wiring may be enhanced.

These and other features of this invention will be better understood and appreciated from the following detailed description taken in conjunction with the drawings.
Fig. 1 is a sectional view of a stage in the method according to the preferred body of the present invention following formation of a first insulation film of semiconductor device; and
Fig. 2 is a sectional view of a further stage in the method according to the same embodiment following the formation of the wiring layer of the device.

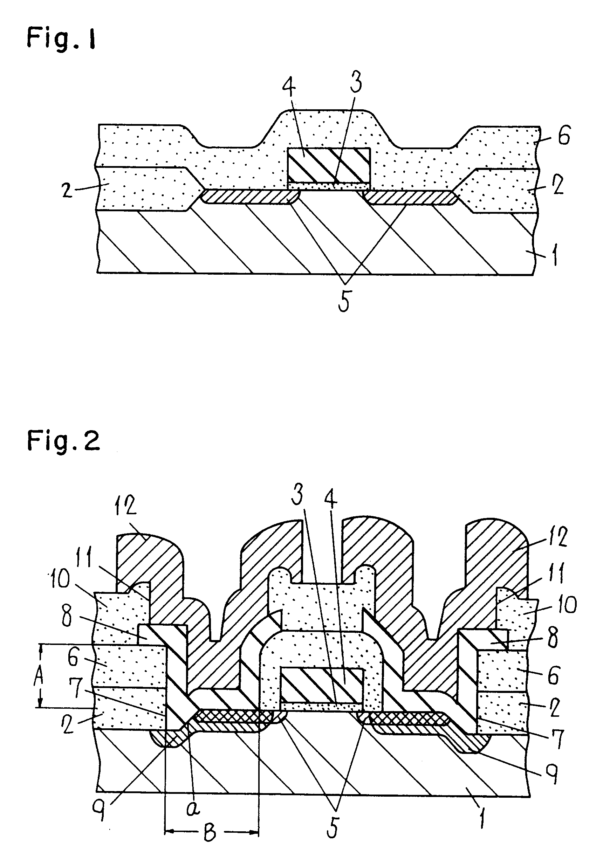

A preferred embodiment of the invention is described below while referring to the sectional views of the manufacturing steps shown in Figs. 1 and 2.

Figs. 1 and 2 show the transistor element part and its peripheral part of a MOS type semiconductor device.

A predetermined surface of a P-type silicon substrate 1 is selectively oxidized, and oxide films 2, 2 for separation of element are formed. Afterwards, by the conventional method, a gate oxide film 3 and a gate electrode 4 are formed near the middle between the oxide films 2, 2 for separation of element. Subsequently, by the self-alignment technique using the gate electrode 4 as mask, an impurity is diffused on the surface of the P-type silicon substrate 1, and a first N⁺ diffusion region 5 is formed as drain and source region. Furthermore, a first insulation film 6 is formed on the entire surface of the P-type silicon substrate 1. In this way, a basic structure of N-channel type MOS transistor is completed.

Next, as shown in Fig. 2, a first contact hole 7 is formed in the first insulation film 6. A part of the periphery of this first contact hole 7 projects from the end of the first N⁺ diffusion region 5, having a width enough to eliminate the edge of the oxide film 2 for separation of element adjacent to the first N⁺ diffusion region 5. Therefore, in this step, a part of the P-type silicon substrate 1 is directly exposed in the first contact hole 7. Afterwards, conductive films are formed on the bottom, inner wall and upper peripheral parts of the first contact hole 7. As the conductive film 8, polysilicon or polycide may be used. Through the conductive film 8, phosphorus ions (P⁺) are implanted at accelerating voltage of 100 keV and dosage of 1 × 10¹⁵/cm², and further by performing heat treatment for activation, a second N⁺ diffusion region 9 is formed in the P-type silicon substrate 1. The second N⁺ diffusion region 9 spreads from beneath the oxide film 2 for separation of element nearly to the gate electrode 4. Therefore, the second N⁺ diffusion region 9 is formed also in the part of the P-type silicon substrate 1 which has been directly exposed in the first contact hole 7. Thus, the conductive film 8 makes an ohmic contact with the first and second N⁺ diffusion regions 5, 9. Incidentally, the first and second N⁺ diffusion regions 5, 9 are partly overlapped with each other to form a single N⁺ diffusion region, of which substantial area is larger than the area of the first N⁺ diffusion region 5. This ohmic contact area spreads over almost entire surface of the first and second N⁺ diffusion regions, 5, 9.

Later, a second insulation film 10 is formed on the surface of the first insulation film 6 and a second contact hole 11 is formed in the second insulation film 10 in order to connect the conductive film 8 to wirings 12 formed on the second insulation film 10. The second contact hole 11 is large enough so that its inner circumference may be close to the outermost circumference of the conductive film 8.

Finally, the wiring layer of aluminum of the like is formed on the surface of the second insulation film 10 and inside the second contact hole 11, and then, the wiring layer is patterned in a required pattern. As a result, the first and second N⁺ diffusion regions 5, 9 are connected to the wirings 12 by way of the conductive film 8.

As described herein, according to this embodiment, it is possible to form the first contact hole 7 having such a large area as to project from the first N+ diffusion region 5 and to remove the edge of the oxide film 2 for separation of element. In other words, it is possible to form the first contact hole having a sufficiently large area without being defined by the area of the first N+ diffusion region 4 or the edge of the oxide film 2 for separation of element. Still more, the area of ohmic contact becomes sufficiently large because the conductive film 8 is formed in the first contact hole 7 having a large area and this conductive film 8 is brought into contact with the diffusion region. Therefore, the contact resistance between the diffusion region and the wiring may be sufficiently reduced. Moreover, the conductive film 8 is formed in this first contact hole 7, and then the second N⁺ diffusion region 9 is formed in the P-type silicon substrate 1 through this conductive film 8. It is hence possible to form the diffusion region having a proper size and a proper position corresponding to the size and position of the first contact hole 7. Therefore, as for positioning of the first N+ diffusion region 5 and first contact hole 7, a sufficiently wide mask matching allowance is provided as compared with the prior art, and this is very effective for enhancing the productivity of semiconductor device.

Besides, since the first contact hole 7 is formed inside the first insulation film 6, the ratio of the width to depth (A/B in Fig. 2) of the first contact hole may be reduced. As a result, formation of the first contact hole 7 itself is easier, and formation failures of the first contact hole 7 may be reduced. Still more, by forming the upper end part of the conductive film 8 up to above the first insulation film 6, the second contact hole 11 which is larger than the first contact hole 7 is formed in the second insulation film 10 on the conductive film 8, so that the formation of second contact hole 11 is easier, and that the ohmic contact between the conductive film 8 and the wirings 12 becomes extremely stable.

As the conductive film 8, meanwhile, polysilicon and polycide can be used, and when polycide is used, the contact resistance between the diffusion region and the wiring may be extremely decreased. In this embodiment, meanwhile, the P-type silicon substarte was used as the semiconductor substrate, but it may be also possible to use an N-type silicon substrate as the semiconductor substrate, and form P⁺ diffusion region as source, drain region.

## Claims

1. A method of manufacturing a semiconductor device comprising the steps of:
forming an oxide film (2) defining a separation region surrounding an active region of a semiconductor device on a surface of a semiconductor substrate (1) of a first conductive type,
forming a first impurity diffusion region (5) of a second conductive type in said active region, wherein at least a section of the periphery of said first impurity diffusion region is adjacent to at least a section of the periphery of said separation region;
forming an insulation film (6) over the surface of said semiconductor substrate (1) and oxide film (2);
forming a contact hole (7) in said insulation film (6) by etching said insulation film (6) and oxide film (2), the contact hole opening generally over said first impurity diffusion region (5), wherein a first section of the periphery of said contact hole is disposed not over said first impurity diffusion region (5) but over said oxide film (2) defining the separation region; and a second section of the periphery of said contact hole is disposed over said first impurity diffusion region (5);
forming a conductive film (8) in electrical contact with the semiconductor substrate (1) and said first impurity diffusion region (5) exposed within said contact hole (7);
forming a second impurity diffusion region (9) of the second conductive type in said semiconductor substrate (1) within said contact hole (7) through said conductive film (8), said second impurity diffusion region (9) being partly overlapped with said first impurity diffusion region (5) together forming a single impurity diffusion region having an area larger than that of said first impurity diffusion region (5); and
forming an electrode (12) electrically connected to said conductive film (8) within said contact hole (7), and thereby to said first and second impurity diffusion regions (5, 9) across substantially the whole area of said first and second impurity diffusion regions (5, 9).

2. A method according to claim 1 of manufacturing a semiconductor device, wherein said conductive film (8) comprises polysilicon or polycide.

## Patentansprüche

1. Ein Verfahren zum Herstellen einer Halbleitervorrichtung mit den Schritten:
Bilden eines Oxidfilms (2), der einen einen aktiven Bereich einer Halbleitervorrichtung auf der Oberfläche eines Halbleitersubstrats (1) eines ersten Leitfähigkeitstyps umgebenden Trennbereich bestimmt,
Bilden eines ersten Dotierstoffdiffusionsbereichs (5) eines zweiten Leitfähigkeitstyps in dem aktiven Bereich, wobei wenigstens ein Randabschnitt des ersten Dotierstoffdiffusionsbereichs an wenigstens einen Randabschnitt des Trennbereichs angrenzt;
Bilden eines Isolationsfilms (6) über der Oberfläche des Halbleitersubstrats (1) und des Oxidfilms (2);
Bilden eines Kontaktlochs (7) in dem Isolationsfilm (6) durch Ätzen des Isolationsfilms (6) und des Oxidfilms (2), wobei das Kontaktloch im allgemeinen den ersten Dotierstoffdiffusionsbereich (5) nach oben freilegt, und wobei ein erster Randabschnitt des Kontaktlochs nicht über dem ersten Dotierstoffdiffusionsbereich (5), sondern über dem Oxidfilm (2), der den Trennbereich bestimmt, angeordnet ist; und ein zweiter Randabschnitt des Kontaktlochs über dem ersten Dotierstoffdiffusionsbereich (5) angeordnet ist;
Bilden eines leitfähigen Films (8), der in elektrischem Kontakt mit dem Halbleitersubstrat (1) und dem ersten, in dem Kontaktloch (7) freiliegenden Dotierstoffdiffusionsbereich (5) steht;
Bilden eines zweiten Dotierstoffdiffusionsbereichs (9) eines zweiten Leitfähigkeitstyps in dem Halbleitersubstrat (1) innerhalb des Kontaktlochs (7) durch den leitfähigen Film (8) hindurch, wobei der zweite Dotierstoffdiffusionsbereich (9) teilweise den ersten Dotierstoffdiffusionsbereich (5) überlappt, um zusammen einen einzigen Dotierstoffdiffusionsbereich mit einer Fläche größer als der des ersten Dotierstoffdiffusionsbereichs (5) zu bilden; und
Bilden einer Elektrode (12), die elektrisch mit dem leitfähigen Film (8) in dem Kontaktloch (7) und damit mit den ersten und zweiten Dotierstoffdiffusionsbereichen (5, 9) über im wesentlichen die gesamte Fläche der ersten und zweiten Dotierstoffdiffusionsbereiche (5, 9) verbunden ist.

2. Ein Verfahren nach Anspruch 1 zum Herstellen einer Halbleitervorrichtung, wobei der leitfähige Film (8) Polysilizium oder Polysilicid umfaßt.

## Revendications

1. Procédé de fabrication d'un dispositif à semi-conducteur, comprenant les étapes suivantes :
la formation d'un film (2) d'oxyde délimitant une région de séparation entourant une région active d'un dispositif à semi-conducteur sur une surface d'un substrat semi-conducteur (1) d'un premier type de conductivité,
la formation d'une première région (5) de diffusion d'impureté d'un second type de conductivité dans ladite région active, un tronçon au moins de la périphérie de la première région de diffusion d'impureté étant adjacent à un tronçon au moins de la périphérie de la région de séparation,
la formation d'un film isolant (6) sur la surface du substrat semi-conducteur (1) et du film d'oxyde (2),
la formation d'un trou de contact (7) dans le film isolant (6) par attaque du film isolant (6) et du film d'oxyde (2), le trou de contact débouchant de façon générale au-dessus de la première région (5) de diffusion d'impureté, un premier tronçon de la périphérie du trou de contact est placé non au-dessus de la première région (5) de diffusion d'impureté mais au-dessus du film d'oxyde (2) délimitant la région de séparation, et un second tronçon de la périphérie du trou de contact est disposé au-dessus de la première région (5) de diffusion d'impureté,
la formation d'un film conducteur (8) en contact électrique avec le substrat semi-conducteur (1) et la première région (5) de diffusion d'impureté exposée dans le trou de contact (7),
la formation d'une seconde région (9) de diffusion d'impureté du second type de conductivité dans le substrat semi-conducteur (1) à l'intérieur du trou de contact (7) à travers le film conducteur (8), la seconde région (9) de diffusion d'impureté étant partiellement recouverte par la première région (5) de diffusion d'impureté qui a une surface supérieure à celle de la première région (5) de diffusion d'impureté, et
la formation d'une électrode (12) connectée électriquement au film conducteur (8) à l'intérieur du trou de contact (7), et ainsi à la première et à la seconde région (5, 9) de diffusion d'impureté sur toute la surface pratiquement des première et seconde régions (5, 9) de diffusion d'impureté.

2. Procédé selon la revendication 1, destiné à la fabrication d'un dispositif à semi-conducteur, dans lequel le film conducteur (8) est formé de silicium polycristallin ou de polycide.
